# EUROPEAN PATENT SPECIFICATION

(11) **EP 2 702 418 B1**
(45) Date of publication and mention of the grant of the patent: **25.03.2015**
(21) Application number: 12730599.3
(22) Date of filing: 26.04.2012
(51) Int. Cl.: G01R 15/22, G01R 22/10, G01R 15/14, G01R 22/06

(54) **GALVANICALLY ISOLATED VOLTAGE MEASUREMENT**
GALVANISCH ISOLIERTE SPANNUNGSMESSUNG
MESURE DE TENSION ISOLEE GALVANIQUEMENT

(30) Priority: 27.04.2011 GB 201106980
(43) Date of publication of application: 05.03.2014
(73) Proprietor: Northern Design (Electronics) Limited, Bradford, West Yorkshire BD3 0QW (GB)
(72) Inventor: SYKES, Ian, Bradford West Yorkshire BD3 0QW (GB); SZAJDZICKA, Julia, Bradford West Yorkshire BD3 0QW (GB); CLAY, Paul, Bradford West Yorkshire BD3 0QW (GB)
(74) Representative: Mohun, Stephen John
(86) International application number: PCT/GB2012/050913
(87) International publication number: WO 2012/146923

(56) References cited:
- DE-A1-102005 039 403
- GB-A- 2 321 713
- GB-A- 2 431 475
- US-A1- 2003 050 737
- US-B1- 7 432 720

## Description

The present invention relates to a method and apparatus for measuring voltage, and in particular as part of an energy metering system.

Currently in domestic and commercial premises energy use is measured using stand-alone meters. Particularly in commercial premises the electricity usage of several devices or appliances, hereinafter referred to generally as "loads", is often monitored using separate meters for each load. In such cases, in order to derive valuable data about the energy usage of each load it is necessary to collate metered values manually, and subsequently enter the data manually on a computer for processing.

More sophisticated meters are configured to send data automatically to a data logging device which may be local, or may be reached via a communications device, for example over the telephone line, or the internet.

As well as measuring the current, which may be achieved for example by using a current transducer, an accurate measurement of voltage is needed to obtain an accurate value for the power consumption.

In a previously considered energy metering system it is customary to measure voltage using a resistive divider network connected directly to the voltages to be measured. The resistive network reduces the potentially dangerous voltages to a low level suitable for input to an electronic measuring system such as a microprocessor analogue to digital converter.

The voltages are measured in reference to the neutral level and it is usual for the electronic measuring system to be connected to this neutral voltage and have all its digital and analogue signals floating within a few volts of the neutral level. However, it is not considered safe to allow the user to have access to any conducting part of an item of equipment that may be connected to the neutral voltage.

This presents a problem to the designers of metering system in that any signals fed out of the measuring equipment, such as communications and pulse outputs, must be galvanically isolated within the metering equipment. This requirement adds complexity and cost to each individual output.

If the voltage measurement inputs were galvanically isolated at the level required to comply with global safety legislation then the measurement electronics (apart from the voltage measurement circuit) could be at a safe voltage and all outputs circuits could be connected directly to this circuit and still remain safe for access by the user.

One approach would be to isolate the measurement voltages using analogue transformers within the equipment. However, such a design would introduce measurement errors and would prove expensive to implement.

GB 2 321 713 describes an electronic circuit for processing high voltage transmission line information. The electronic circuit includes a signal conversion circuit operating at a line potential and operably coupled to at least one high voltage transmission line for converting information on at least one line parameter of a high voltage transmission line into a processable format. The electronic circuit further includes an opto-coupler operably coupled to the signal conversion circuit for transmitting information on the at least one line parameter from the signal conversion circuit to a processing circuit at a ground potential for processing the line parameter information from the signal conversion circuit.

US 7 432 720 describes a method for monitoring an electrical characteristic on an electronic circuit board. This electrical characteristic can be voltage or current. The electrical characteristic is measured at a first location, which is at a high voltage called primary potential. The electrical characteristic is converted to a proportional frequency which is sent through an isolation circuit to a second location for monitoring. The second location is at a low voltage called secondary potential. The frequency is provided as input to an environment monitoring circuit at the second location.

DE 10 2005 039403 describes an energy consumption recording device for one or multiple consumers having an integrated measuring ring for supply of an adjusting signal which is supplied as a partial, optical or inductive connection to an evaluation circuit.

US 2003/050737 describes an "energy smart" home system where the existing proliferation of electrical junction boxes in the typical home or building are used for a combination of purposes, supporting diverse functionalities and enabling ease of installation with no new wiring. Typically, this system relies on powerline communication and uses electrical wiring for energy distribution, monitoring, and control as well as security, audio/video communications and entertainment, and general network communications such as file transfers and Internet connectivity.

Preferred embodiments of the present invention aim to address at least some of the aforementioned shortcomings in the prior systems.

The present invention is defined in the attached independent claims, to which reference should now be made. Further, preferred features may be found in the sub-claims appended thereto.

According to one aspect of the present invention there is provided a method of measuring voltage comprising converting an analogue voltage waveform to a digital signal, representative of the analogue voltage waveform, transmitting the representative digital voltage signal across an isolation barrier and distributing the representative digital signal to a number of measurement devices.

Preferably the method includes attenuating the analogue voltage waveform prior to converting it into the representative digital voltage signal.

In a preferred arrangement the method comprises converting the analogue voltage waveform at a single first location and distributing the representative digital voltage signal to measurement devices at a plurality of second locations, at least some of which may be remote from said first location.

Preferably the method comprises transmitting to the number of measurement devices a synchronising signal, along with the representative digital voltage signal.

The method may comprise transmitting the representative digital voltage signal and the synchronising signal to measurement devices that comprise current measurement devices and derive power and/or other measurements.

The representative digital voltage signal may comprise a digital voltage data packet and, as an alternative or in addition, a synchronising signal for the measurement devices may comprise the start of the digital voltage data packet.

The method may form part of a method of measuring power consumption of a load and may include transmitting the representative digital voltage signal and a synchronising signal to an electricity meter which is arranged to measure current, and synchronising the current and voltage measurement to obtain a power measurement.

The invention also includes apparatus for measuring voltage comprising a converter for converting an analogue voltage waveform to a representative digital voltage signal, and an output arranged to provide the representative digital voltage signal to a number of measurement devices, wherein the output is separated from the converter by an isolation barrier.

In a preferred arrangement the apparatus is arranged in use to attenuate the analogue voltage waveform before it is converted into the representative digital voltage signal.

Preferably the output is arranged to provide the representative digital voltage signal to a number of measurement devices located remotely from the converter.

In a preferred arrangement the converter comprises a microprocessor. Preferably the microprocessor is arranged to generate a synchronising signal for the measurement devices. As an alternative, or in addition, a synchronising signal may be taken as the start of a digital data voltage packet in the representative digital voltage signal.

The measurement devices may comprise current measurement devices and derive power and/or other measurements.

In a preferred arrangement the output is arranged to provide a synchronising signal and the representative digital voltage signal to a plurality of power measurement devices located remotely from the converter, which use the synchronising signal to synchronise the measurement of electrical current with the voltage signal.

The isolation barrier may comprise an optical isolation barrier.

The invention may comprise any combination of the features or limitations referred to herein, except such a combination of features as are mutually exclusive.

A preferred embodiment of the present invention will now be described by way of example only, with reference to the accompanying diagrammatic drawings in which:

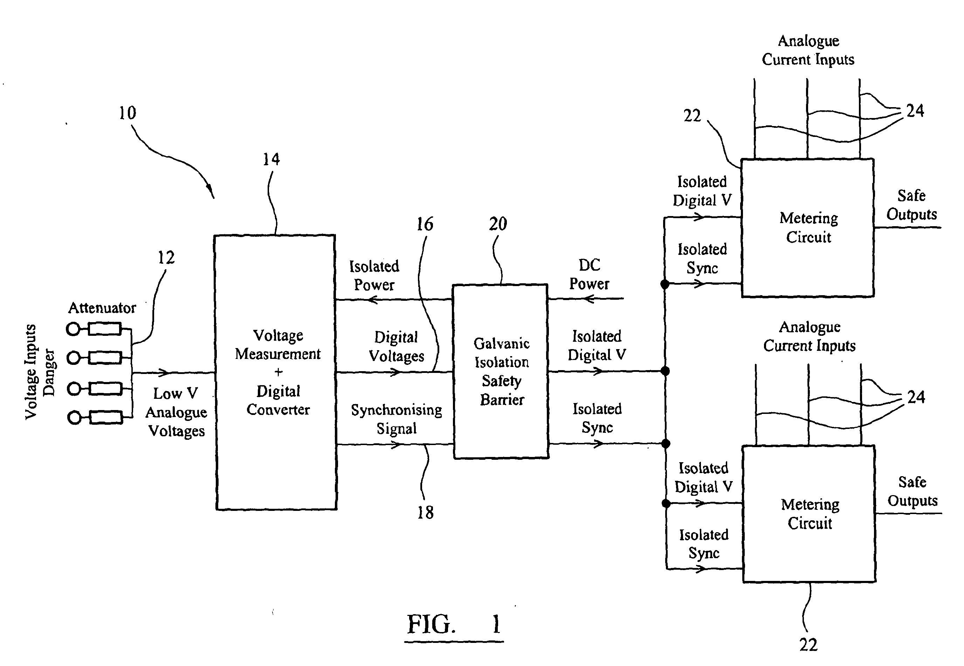

Figure 1 is a schematic circuit diagram showing a voltage measurement apparatus, in accordance with an embodiment of the present invention.

The present invention relies upon the fact that digital signals can be transmitted across an isolation barrier (such as an optical isolation barrier) without loss of information. Embodiments of the present invention measure the voltages using a microprocessor circuit, local to the voltage measurement inputs - i.e local to the loads - to sample the voltage waveforms multiple times per power cycle. The microprocessor then sends a digital representation of the voltage waveforms, along with a synchronising signal, across a safety isolation barrier.

Referring to Figure 1, there is shown, schematically generally at 10, an embodiment of voltage measurement apparatus, according to the invention.

High - i.e. un-attenuated - voltages are connected to attenuator 12, which then feeds attenuated voltage waveforms to a microprocessor-based analogue-digital converter/voltage measurement circuit 14. A representative digital voltage signal 16 and a synchronising signal 18 are then sent across an optical isolation barrier 20, and are then output to metering circuits 22. The metering circuits 22 receive analogue current inputs 24 which are sampled in synchronism with the digital voltage signals for an accurate measurement of power. Safe outputs 26 are provided which are isolated from any dangerous voltage.

Accuracy is determined by the microprocessor circuit local to the converter/voltage measurement circuit 14 and this is maintained by sending values numerically as bits/bytes across the isolation barrier 20. By tailoring the measurement circuit 14 to the application, ie the type of load (not shown), various levels of accuracy can be obtained.

The digital voltage values sent across the isolation barrier 20 may be picked up by a second microprocessor in the metering circuit 22 which can combine the values with samples of current waveforms and thus produce the same functionality of fully - featured, multiple - parameter power measurement devices.

The synchronising signal 18 allows the accurate combination of multiple samples of voltages and currents per input power cycle with no time shift. This is essential for an accurate determination of parameters such as kW.

In an alternative embodiment (not shown) the synchronising signal can be derived from the start of the digital voltage data packet. This advantageously removes the need for a separate synchronising signal, and hence only a single channel isolating barrier may be needed.

This accurate digital voltage isolation system can be used in other devices which require accurate voltage measurement such as digital voltage transducers which do not necessarily require current measurements.

The digitally isolated voltage signals can be simultaneously transmitted to a number of power meters 22 designed to take this form of voltage input. The individual meters are lower in complexity since they have no voltage measurement inputs, and therefore they are less expensive than previously considered devices. The transmission medium can be designed to suit transmission over short or long distances and can be wired, as shown in Figure 1, or else can be wireless.

The isolation barrier 20 in the above example is an optical isolation barrier, but other types of isolation could be employed.

## Claims

1. A method of measuring voltage comprising converting an analogue voltage waveform to a digital signal, representative of the analogue voltage waveform, transmitting the representative digital voltage signal across an isolation barrier (20) and distributing the representative digital signal to a number of measurement devices (22), **characterised in that** the method further comprises providing to the number of measurement devices a synchronising signal, along with the representative digital voltage signal.

2. A method according to Claim 1, including attenuating the analogue voltage waveform prior to converting it into the representative digital voltage signal.

3. A method according to Claim 1 or 2, comprising converting the analogue voltage waveform at a single first location and distributing the representative digital voltage signal to measurement devices at a plurality of second locations.

4. A method according to any of Claims 1 to 3, comprising providing the representative digital voltage signal and the synchronising signal to measurement devices that comprise voltage measurement devices or power measurement devices.

5. A method according to any of Claims 1 to 4, wherein the synchronising signal is derived from the start of a digital voltage data packet.

6. A method according to any of the preceding claims in which the method forms part of a method of measuring power consumption of a load.

7. Apparatus for measuring voltage comprising a converter (14) for converting an analogue voltage waveform to a representative digital voltage signal, and an output arranged to provide the representative digital voltage signal to a number of measurement devices (22), wherein the output is separated from the converter by an isolation barrier (20), **characterised in that** the apparatus is arranged in use to provide a synchronising signal (18) to the or each measurement device.

8. Apparatus according to Claim 7, wherein the apparatus is arranged in use to attenuate the analogue voltage waveform before it is converted into the representative digital voltage signal.

9. Apparatus according to Claim 7 or 8, wherein the output is arranged to provide the representative digital voltage signal to a number of measurement devices located remotely from the converter.

10. Apparatus according to any of Claims 7 to 9, wherein the synchronising signal is derived from the start of a digital voltage data packet.

11. Apparatus according to any of Claims 7 to 10, wherein the converter comprises a microprocessor.

12. Apparatus according to Claim 11, wherein the microprocessor is arranged to generate the synchronising signal for the measurement devices.

13. Apparatus according to any of Claims 7 to 12, wherein the or each measurement device comprises a voltage measurement device or a power measurement device.

14. Apparatus according to any of Claims 7 to 13, wherein the output is arranged to provide the synchronising signal and the representative digital voltage signal to a plurality of power measurement devices located remotely from the converter, which use the synchronising signal to synchronise the measurement of electrical current with the voltage signal.

15. Apparatus according to any of Claims 7 to 14, wherein the isolation barrier comprises an optical isolation barrier.

## Patentansprüche

1. Verfahren zum Messen einer Spannung, umfassend das Umwandeln einer analogen Spannungswellenform in ein digitales Signal, das für die analoge Spannungswellenform repräsentativ ist, Übertragen des repräsentativen digitalen Spannungssignals über eine Isolationsbaruere (20) und Verteilen des repräsentativen digitalen Signals an eine Anzahl von Messeinrichtungen (22), **dadurch gekennzeichnet, dass** das Verfahren weiterhin umfasst, dass an die Anzahl von Messeinrichtungen ein Synchronisierungssignal zusammen mit dem repräsentativen digitalen Spannungssignal geliefert wird.

2. Verfahren nach Anspruch 1, **dadurch gekennzeichnet, dass** die analoge Spannungswellenform gedämpft wird, bevor sie in das repräsentative digitale Spannungssignal umgewandelt wird.

3. Verfahren nach Anspruch 1 oder 2, **dadurch gekennzeichnet, dass** die analoge Spannungswellenform an einem einzelnen ersten Ort umgewandelt wird und das repräsentative digitale Spannungssignal an einer Anzahl von zweiten Orten an Messeinrichtungen verteilt wird.

4. Verfahren nach einem der Ansprüche 1 bis 3, **dadurch gekennzeichnet, dass** das repräsentative digitale Spannungssignal und das Synchronisierungssignal an Messeinrichtungen geliefert werden, die Spannungsmesseinrichtungen oder Leistungsmesseinrichtungen umfassen.

5. Verfahren nach einem der Ansprüche 1 bis 4, **dadurch gekennzeichnet, dass** das Synchronisierungssignal aus dem Start eines digitalen Spannungsdatenpakets abgeleitet wird.

6. Verfahren nach einem der vorangehenden Ansprüche, **dadurch gekennzeichnet, dass** das Verfahren einen Teil eines Verfahrens zum Messen des Stromverbrauchs einer Last bildet.

7. Vorrichtung zum Messen einer Spannung, umfassend einen Wandler (14) zum Umwandeln einer analogen Spannungswellenform in ein repräsentatives digitales Spannungssignal, und einen Ausgang, der eingerichtet ist, um das repräsentative digitale Spannungssignal an eine Anzahl von Messeinrichtungen (22) anzugeben, wobei der Ausgang von dem Wandler durch eine Isolationsbaruere (20) getrennt ist, **dadurch gekennzeichnet, dass** die Vorrichtung eingerichtet ist, um im Gebrauch ein Synchronisierungssignal (18) an die oder jede Messeinrichtung zu liefern.

8. Vorrichtung nach Anspruch 7, **dadurch gekennzeichnet, dass** die Vorrichtung eingerichtet ist, um im Gebrauch die analoge Spannungswellenform zu dämpfen, bevor sie in das repräsentative digitale Spannungssignal umgewandelt wird.

9. Vorrichtung nach Anspruch 7 oder 8, **dadurch gekennzeichnet, dass** der Ausgang eingerichtet ist, um das repräsentative digitale Spannungssignal an eine Anzahl von Messeinrichtungen zu liefern, die entfernt von dem Wandler angeordnet sind.

10. Vorrichtung nach einem der Ansprüche 7 bis 9, **dadurch gekennzeichnet, dass** das Synchronisierungssignal aus dem Start eines digitalen Spannungsdatenpakets abgeleitet wird.

11. Vorrichtung nach einem der Ansprüche 7 bis 10, **dadurch gekennzeichnet, dass** der Wandler einen Mikroprozessor umfasst.

12. Vorrichtung nach Anspruch 11, **dadurch gekennzeichnet, dass** der Mikroprozessor eingerichtet ist, um das Synchronisierungssignal für die Messeinrichtungen zu erzeugen.

13. Vorrichtung nach einem der Ansprüche 7 bis 12, **dadurch gekennzeichnet, dass** die oder jede Messeinrichtung eine Spannungsmesseinrichtung oder eine Leistungsmesseinrichtung umfasst.

14. Vorrichtung nach einem der Ansprüche 7 bis 13, **dadurch gekennzeichnet, dass** der Ausgang eingerichtet ist, um das Synchronisierungssignal und das repräsentative digitale Spannungssignal an eine Anzahl von Leistungsmesseinrichtungen zu liefern, die entfernt von dem Wandler angeordnet sind und die das Synchronisierungssignal verwenden, um die Messung des elektrischen Stroms mit dem Spannungssignal zu synchronisieren.

15. Vorrichtung nach einem der Ansprüche 7 bis 14, **dadurch gekennzeichnet, dass** die Isolationsbarriere eine optische Isolationsbarriere umfasst.

## Revendications

1. Procédé de mesure d'une tension comprenant la conversion d'une forme d'onde de tension analogique en un signal numérique représentatif de la forme d'onde de tension analogique, la transmission du signal numérique de tension représentatif à travers une barrière galvanique (20) et la distribution du signal numérique représentatif à un certain nombre de dispositifs de mesure (22), **caractérisé en ce que** le procédé comprend en outre la fourniture à l'ensemble de dispositifs de mesure d'un signal de synchronisation, simultanément au signal numérique de tension représentatif.

2. Procédé selon la revendication 1, comportant l'atténuation de la forme d'onde de tension analogique avant sa conversion en signal de tension numérique représentatif.

3. Procédé selon la revendication 1 ou 2, comprenant la conversion de la forme d'onde de tension analogique à un premier emplacement unique et la distribution du signal de tension numérique représentatif à des dispositifs de mesure au niveau d'une pluralité de seconds emplacements.

4. Procédé selon l'une quelconque des revendications 1 à 3, comprenant la fourniture du signal de tension numérique représentatif et du signal de synchronisation à des dispositifs de mesure qui comprennent des dispositifs de mesure de tension ou des dispositifs de mesure de puissance.

5. Procédé selon l'une quelconque des revendications 1 à 4, dans lequel le signal de synchronisation est dérivé à partir du début d'un paquet de données de tension numérique.

6. Procédé selon l'une quelconque des revendications précédentes, dans lequel le procédé constitue une partie d'un procédé de mesure de consommation d'énergie d'une charge.

7. Dispositif de mesure de tension comprenant un convertisseur (14) destiné à convertir une forme d'onde de tension analogique en un signal de tension numérique représentatif, et une sortie agencée de manière à délivrer le signal de tension numérique représentatif à un certain nombre de dispositifs de mesure (22), dans lequel la sortie est séparée du convertisseur par une barrière galvanique (20), **caractérisé en ce que** le dispositif est agencé, en utilisation, de manière à délivrer un signal de synchronisation (18) au ou à chaque dispositif de mesure.

8. Dispositif selon la revendication 7, dans lequel le dispositif est agencé, en utilisation, de manière à atténuer la forme d'onde de tension analogique avant qu'elle soit convertie en signal de tension numérique représentatif.

9. Dispositif selon la revendication 7 ou 8, dans lequel la sortie est agencée de manière à délivrer le signal numérique de tension représentatif à un certain nombre de dispositifs de mesure situés à distance par rapport au convertisseur.

10. Dispositif selon l'une quelconque des revendications 7 à 9, dans lequel le signal de synchronisation est déduit du début d'un paquet de données de tension numérique.

11. Dispositif selon l'une quelconque des revendications 7 à 10, dans lequel le convertisseur comprend un microprocesseur.

12. Dispositif selon la revendication 11, dans lequel le microprocesseur est agencé afin de produire le signal de synchronisation pour les dispositifs de mesure.

13. Dispositif selon l'une quelconque des revendications 7 à 12, dans lequel le ou chaque dispositif de mesure comprend un dispositif de mesure de tension ou un dispositif de mesure de puissance.

14. Dispositif selon l'une quelconque des revendications 7 à 13, dans lequel la sortie est agencée de manière à délivrer le signal de synchronisation et le signal de tension numérique représentatif à une pluralité de dispositifs de mesure de puissance, situés à distance par rapport au convertisseur, qui utilisent le signal de synchronisation afin de synchroniser la mesure du courant électrique avec le signal de tension.

15. Dispositif selon l'une quelconque des revendications 1 à 14, dans lequel la barrière galvanique comprend une barrière galvanique optique.
